# EUROPEAN PATENT APPLICATION

(11) **EP 3 372 419 A1**
(43) Date of publication of application: **12.09.2018**
(21) Application number: 16861892.4
(22) Date of filing: 12.10.2016
(51) Int. Cl.: B41N 1/14, B41M 1/08, B41N 1/16, G03F 7/00, G03F 7/09, G03F 7/11

(54) **OFFSET PRINTING PLATE, OFFSET PRINTING APPARATUS, AND OFFSET PRINTING METHOD**

(30) Priority: 06.11.2015 JP 2015218469
(71) Applicant: Think Laboratory Co., Ltd., Kashiwa-shi Chiba 277-8525 (JP)
(72) Inventor: SHIGETA, Tatsuo, Kashiwa-shi Chiba 277-8525 (JP)
(74) Representative: Mincone, Antimo
(86) International application number: PCT/JP2016/080209
(87) International publication number: WO 2017/077825

(57) **Abstract**

Provided are an offset printing plate, an offset printing apparatus, and an offset printing method, which are capable of printing a high-definition image by waterless offset printing.

The offset printing plate comprises: a cylindrical plate base material; a silicon resin layer formed on the cylindrical plate base material; and a resist pattern part formed on the silicon resin layer, in which the silicon resin layer serves as a non-printing area, and the resist pattern part serves as a printing area. The silicon resin layer is preferably formed on the cylindrical plate base material seamlessly.

## Description

### Technical Field

The present invention relates to an offset printing plate, in particular, an offset printing plate to be used suitably in waterless offset printing that does not require dampening water, an offset printing apparatus, and an offset printing method.

### Background Art

A general offset printing system is a printing system of performing printing which involves forming satin-like fine roughness on a surface of a plate material (which is also called a plate) made of, for example, aluminum, forming a printing area and a non-printing area on the rough surface of the plate material to provide a plate, winding the plate around a plate cylinder, transferring an ink supplied to a plate surface to a rubber blanket, and inserting paper between the rubber blanket and an impression cylinder. In printing, an oil-based ink is supplied to the printing area, and water (also containing a small amount of isopropyl alcohol) called dampening water is supplied to the non-printing area, to thereby perform printing through repulsion between water and oil.

Meanwhile, there is also a printing system called waterless offset printing (waterless planographic printing), which does not involve use of dampening water unlike the above-mentioned general offset printing system. This waterless offset printing is a system of performing printing which involves forming a non-printing area through use of, in place of water, silicon rubber having properties of repelling an ink to provide a plate. The plate to be used in such waterless offset printing is prepared as follows. The silicon rubber is bonded to a film, and a mask and a negative film are bonded to the silicon rubber. The resultant silicon rubber is exposed to light. An area having the silicon rubber peeled off by exposure to light serves as a printing area to which an ink adheres, and an area having the remaining silicon rubber serves as a non-printing area.

Further, as an offset plate to be used in offset printing which does not involve use of water, a direct offset plate-making method using a pulse laser has also been proposed (Patent Document 1).

However, there has been the following problem. When a resin layer made of, for example, silicon rubber is melted and evaporated with a pulse laser, heat is generated to smoothen shoulder portions of the printing area and the non-printing area, with the result that a high-definition image cannot be formed. Further, in recent years, for example, in patterning printing for an electronic circuit, there is an increasing demand for printing a high-definition image. Further, when the resin layer made of, for example, silicon rubber is melted and evaporated with a pulse laser, it is necessary to suck gas generated by vaporization so that the gas does not adhere to a lens of a laser head and the like.

### Prior Art Documents

### Patent Documents

Patent Document 1: JP Hei 8-300599 A
Patent Document 2: JP 2010-222580 A

### Summary of the Invention

### Problems to be solved by the Invention

It is an object of the present invention to provide an offset printing plate, an offset printing apparatus, and an offset printing method, which are capable of printing a high-definition image by waterless offset printing.

### Means for Solving Problems

In order to solve the above-mentioned problems, an offset printing plate according to the present invention comprises: a cylindrical plate base material; a silicon resin layer formed on the cylindrical plate base material; and a resist pattern part formed on the silicon resin layer, in which the silicon resin layer serves as a non-printing area, and the resist pattern part serves as a printing area.

The silicon resin layer is preferably formed on the cylindrical plate base material seamlessly.

The offset printing plate is preferably used in waterless offset printing that does not require dampening water at a time of printing.

An offset printing apparatus according to the present invention is configured to perform offset printing by applying an electron beam curable ink to the above-mentioned offset printing plate, the offset printing apparatus comprising: the offset printing plate; a blanket cylinder; an impression cylinder; and an electron beam irradiation device, in which the electron beam curable ink is cured with the electron beam irradiation device arranged above a material to be printed.

An offset printing method according to the present invention uses the above-mentioned offset printing apparatus, comprising: applying an electron beam curable ink to an offset printing plate; transferring the electron beam curable ink from the offset printing plate to a blanket cylinder; transferring the electron beam curable ink from the blanket cylinder to a material to be printed; and curing the electron beam curable ink with an electron beam irradiation device.

A printed matter according to the present invention is printed by the above-mentioned offset printing method.

### Advantageous Effects of the Invention

According to the present invention, there is provided a remarkable effect of being capable of providing the offset printing plate, the offset printing apparatus, and the offset printing method, which are capable of printing a high-definition image by waterless offset printing.

### Brief Description of Drawings

FIG. 1 is a sectional view of a main part for illustrating an embodiment of an offset printing plate according to the present invention.
FIG. 2 is a sectional view of a main part for schematically illustrating a method of manufacturing the offset printing plate of the present invention, and shows a state in which a cylindrical plate base material is prepared in (a), a state in which a silicon resin layer is formed on a surface of the cylindrical plate base material in (b), a state in which a photosensitive material is applied to a surface of the silicon resin layer in (c), and a state in which a resist pattern part is formed by exposure and development in (d), respectively.
FIG. 3 is a schematic view of a main part of an offset printing apparatus using the offset printing plate of the present invention.

### Modes for Carrying out the Invention

Embodiments of the present invention are described below. However, those embodiments are described as examples, and hence it is understood that various modifications may be made thereto without departing from the technical spirit of the present invention. In addition, the same members are denoted by the same reference symbols.

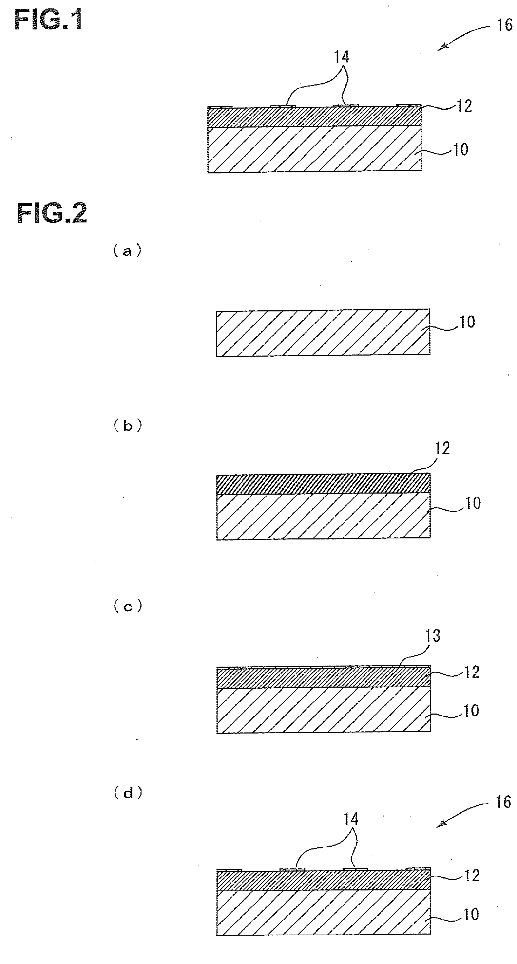

An embodiment of an offset printing plate according to the present invention is illustrated in FIG. 1. In FIG. 1, the reference symbol 16 denotes an offset printing plate of the present invention.

The offset printing plate 16 of the present invention is an offset printing plate constructed so as to comprise a hollow cylindrical plate base material 10, a silicon resin layer 12 formed on the plate base material 10, and a resist pattern part 14 formed on the silicon resin layer 12.

In the offset printing plate 16, the silicon resin layer 12 serves as a non-printing area (area to which an ink does not adhere by being repelled), and the resist pattern part 14 serves as a printing area (area to which an ink adheres). Therefore, offset printing can be performed without use of dampening water. Printing with use of water can also be performed, but printing without use of water has an advantage in that registration accuracy is high.

FIG. 2 is a sectional view of a main part for schematically illustrating a method of manufacturing the offset printing plate 16 of the present invention.

First, the hollow cylindrical plate base material 10 is prepared (FIG. 2(a)). As a material for the cylindrical plate base material, any known cylindrical plate base material, for example, a metal such as aluminum or iron and CFRP is applicable as long as the material can be formed into a cylindrical plate base material. Satin-like fine roughness is formed on a surface of the cylindrical plate base material 10 by treatment such as sandblasting.

Then, the silicon resin layer 12 is formed without a seam (seamlessly) on the surface of the cylindrical plate base material 10 (FIG. 2(b)). As a method of forming the silicon resin layer 12, there is given, for example, a method of coating with a liquid silicon resin. A thickness of the silicon resin layer 12 is preferably from about 1 mm to about 10 mm, but there is no particular upper limit of the thickness of the silicon resin layer 12.

Next, a photosensitive material 13 is applied to a surface of the silicon resin layer 12 (FIG. 2(c)). An application thickness of the photosensitive material 13 is preferably from about 0.1 µm to about 10 µm.

Then, the photosensitive material 13 is subjected to exposure and development to form the resist pattern part 14 (FIG. 2(d)). With this, an area in which the silicon resin layer 12 is exposed is formed. The area in which the silicon resin layer 12 is exposed serves as a non-printing area, and the resist pattern part 14 serves as a printing area. Thus, the offset printing plate 16 is completed.

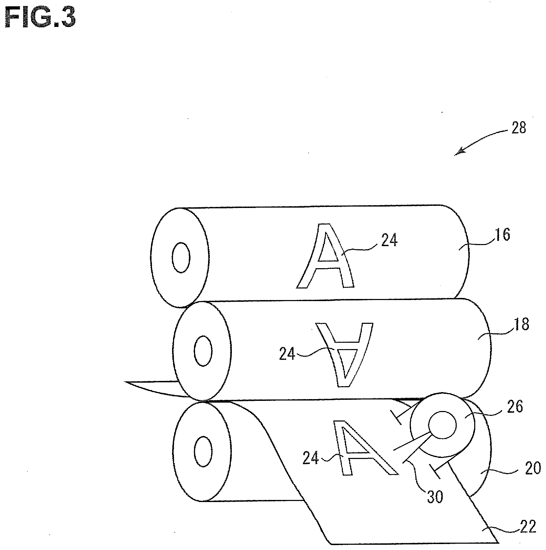

Next, an embodiment of an offset printing apparatus using the offset printing plate 16 of the present invention is illustrated in FIG. 3.

In FIG. 3, the reference symbol 28 denotes an offset printing apparatus of the present invention. The offset printing apparatus 28 is an offset printing apparatus which is configured to perform offset printing by applying an electron beam curable ink 24 to the offset printing plate 16. The offset printing apparatus 28 comprises the offset printing plate 16, a blanket cylinder 18, an impression cylinder 20, and an electron beam irradiation device 26. The electron beam curable ink 24 is cured by irradiation with an electron beam 30 with the electron beam irradiation device 26 arranged above a material 22 to be printed.

In the illustrated example, paper is exemplified as the material 22 to be printed, but a plastic film or the like can also be used. In the illustrated example, the electron beam irradiation device 26 is arranged above the material 22 to be printed, which is being conveyed, at a distance. As the electron beam irradiation device 26, a device which is known as a device capable of performing irradiation of the electron beam 30 can be used.

In the offset printing apparatus 28, an electron beam curable ink is used. As an electron beam curable ink to be used in the offset printing apparatus 28, any offset ink that is cured by irradiation with the electron beam 30 may be used. For example, an electron beam curable ink disclosed in Patent Document 2 can be used.

An offset printing method using the offset printing apparatus 28 comprises: applying the electron beam curable ink 24 to the offset printing plate 16; transferring the electron beam curable ink 24 from the offset printing plate 16 to the blanket cylinder 18; transferring the electron beam curable ink 24 from the blanket cylinder 18 to the material 22 to be printed; and curing the electron beam curable ink 24 with the electron beam irradiation device 26. Thus, a printed matter is manufactured.

In the above-mentioned example, description is given of the case using an electron beam curable ink. However, with the offset printing plate 16 of the present invention, offset printing with use of water in the same manner as in the related art or waterless offset printing can also be performed through use of an offset ink that is not an electron beam curable ink, for example, an oil-based ink or a UV-curable ink.

### Reference Signs List

10: cylindrical plate base material, 12: silicon resin layer, 13: photosensitive material, 14: resist pattern part, 16: offset printing plate, 18: blanket cylinder, 20: impression cylinder, 22: material to be printed, 24: electron beam curable ink, 26: electron beam irradiation device, 28: offset printing apparatus, 30: electron beam.

## Claims

1. An offset printing plate, comprising:
a cylindrical plate base material;
a silicon resin layer formed on the cylindrical plate base material; and
a resist pattern part formed on the silicon resin layer,
wherein the silicon resin layer serves as a non-printing area, and the resist pattern part serves as a printing area.

2. An offset printing plate according to claim 1, wherein the silicon resin layer is formed on the cylindrical plate base material seamlessly.

3. An offset printing plate according to claim 1 or 2, wherein the offset printing plate is used in waterless offset printing that does not require dampening water at a time of printing.

4. An offset printing apparatus which is configured to perform offset printing by applying an electron beam curable ink to the offset printing plate of any one of claims 1 to 3, the offset printing apparatus comprising:
the offset printing plate;
a blanket cylinder;
an impression cylinder; and
an electron beam irradiation device,
wherein the electron beam curable ink is cured with the electron beam irradiation device arranged above a material to be printed.

5. An offset printing method using the offset printing apparatus of claim 4, comprising:
applying an electron beam curable ink to an offset printing plate;
transferring the electron beam curable ink from the offset printing plate to a blanket cylinder;
transferring the electron beam curable ink from the blanket cylinder to a material to be printed; and
curing the electron beam curable ink with an electron beam irradiation device.

6. A printed matter which is printed by the offset printing method of claim 5.
